# EUROPEAN PATENT APPLICATION

(11) **EP 4 746 105 A1**
(43) Date of publication of application: **20.05.2026**
(21) Application number: 24212755.3
(22) Date of filing: 13.11.2024
(51) Int. Cl.: H01M 10/42, H01M 10/48, G01R 31/36, G01R 31/3835, G01R 31/392, G01R 31/52

(54) **SENSING SPACER, SYSTEM AND METHOD FOR DETERMINING ABNORMAL VOLTAGE DROP IN BATTERY CELLS**

(71) Applicant: LG Energy Solution, Ltd., Seoul 07335 (KR)
(72) Inventor: CHOI, Jin Hyeong, 34122 Daejeon (KR); KIM, Min Hyung, 34122 Daejeon (KR); KIM, Sung Yun, 34122 Daejeon (KR)
(74) Representative: Goddar, Heinz J.

(57) **Abstract**

The application relates to a sensing spacer (300), the sensing spacer (300) comprising a base element (310) and an electrically conducting element (320) arranged on the base element (310), the electrically conducting element (320) being configured to contact an electrode (212).

## Description

### FIELD OF THE INVENTION

The present disclosure relates to a sensing spacer for contacting electrodes. The disclosure further relates to a system and method for determining abnormal voltage drops in battery cells of battery modules. The invention may relate to determining open circuit voltages to identify battery cells exhibiting abnormal voltage behavior.

### BACKGROUND OF THE INVENTION

In the field of battery technology, ensuring the reliability and performance of battery cells, particularly within battery modules, is of paramount importance. Battery modules are widely used in various applications, including electric vehicles, consumer electronics, portable electronics, and renewable energy storage systems, due to their high energy density and flexible form factor.

An abnormal voltage drop can indicate potential issues such as internal short circuits, degradation of cell materials, or manufacturing defects, which can compromise the overall performance and safety of the battery module.

In particular, battery cells and/or electrodes may be defective or otherwise impaired, such that the performance of a battery module including said battery cells and/or electrodes may be decreased.

Thus, it is desirable to inspect or test battery modules, battery cells and/or electrodes after manufacturing a battery module.

Known methods and systems typically involve periodic monitoring of the voltage of battery cells using external sensors and diagnostic tools. These systems often rely on manual inspection or the use of complex and expensive equipment to measure the open circuit voltage (OCV) of battery cells. However, these approaches can be time-consuming, labor-intensive, and may not provide real-time data, making it difficult to promptly identify and address issues. These known procedures can take several days to carry out and/or be completed, and measurements need to be taken over three days or more.

Despite the substantial advances in the field of battery diagnostics, there remains a need for more efficient, accurate, and real-time methods to detect abnormal voltage drops in battery cells. Further, current methods may not offer the precision required to identify subtle voltage variations that could indicate early signs of cell failure.

It is therefore a technical problem underlying the present invention to provide a sensing spacer, a system and a method for determining whether a battery cell of a battery module has an abnormal voltage drop that at least partially overcomes the disadvantages of known methods and systems.

### SUMMARY OF THE INVENTION

It is an object of this invention to provide methods that overcome one or more of the disadvantages of known methods.

The present invention is defined by the subject-matter of the appended independent claim(s). Particular examples are given by the features of the dependent claims.

In particular, the problems known from the prior art may be overcome by a sensing spacer, a system according and/or a method as defined in the appended claims. The dependent claims refer to particularly preferable embodiments of the invention.

According to an aspect of the invention, a sensing spacer is provided. The sensing spacer may comprise a base element. The sensing spacer may comprise an electrically conducting element. The electrically conducting element may be arranged on the base element. The electrically conducting element may be configured to contact an electrode.

The sensing spacer may be used to measure and/or determine electrical properties of battery cells. The sensing spacer may be used to measure and/or determine electrical properties of electrodes.

The sensing spacer may be configured to contact an electrode. The sensing spacer may be configured to contact an exposed tab of an electrode. The electrically conducting element may be configured to contact a tab of an electrode. The electrically conducting element may be configured to contact an electrode. A "contact" may mean a physical contact. A "contact" may mean a direct contact. A "contact" may mean an electrical contact.

The base element may comprise a base layer. The base element may be or may comprise an OHP film. Alternatively or additionally, the base layer may be or may comprise an OHP film. The base element may be or may comprise an insulating film and/or an insulating layer. The base element may be configured to protect or shield the electrically conducting element from electrical interference or contact with other conductive materials. The base element may be electrically non-conductive. The base element may be insulating. The base layer may be electrically non-conductive. The base layer may be insulating. The OHP film may be electrically non-conductive. The OHP film may be insulating.

The electrically conducting element may be arranged on the base layer. For example, when the electrically conducting element is arranged on the base element, it may be arranged on the base layer. The electrically conducting element may be arranged on the OHP film. For example, when the electrically conducting element is arranged on the base element, it may be arranged on the OHP film.

"Arranged on" may refer to the electrically conducting element being attached and/or being mounted on the base element. Alternatively or additionally, "arranged on" may refer to the electrically conducting element being attached and/or being mounted on the base layer and/or the OHP film. "Arranged on" may mean that the electrically conducting element may be disposed over the base element. Alternatively or additionally, "arranged on" may mean that the electrically conducting element may be disposed over the base layer and/or the OHP film. "Arranged on" may mean that the electrically conducting element may be mechanically connected to the base element. Alternatively or additionally, "arranged on" may mean that the electrically conducting element may be mechanically connected to the base layer and/or the OHP film. "Arranged on" may mean that the electrically conducting element may be in direct contact with the base element. Alternatively or additionally, "arranged on" may mean that the electrically conducting element may be in direct contact with the base layer and/or the OHP film. Alternatively or additionally, at least one additional element may be situated between the electrically conducting element and the base element. Alternatively or additionally, at least one additional element may be situated between the electrically conducting element and the base layer. Alternatively or additionally, at least one additional element may be situated between the electrically conducting element and the OHP film. The at least one additional element may be or may comprise an additional layer. For instance, the electrically conducting element may not necessarily be in direct contact with the base element.

The base element may provide structural support. The base layer may provide structural support. The OHP film may provide structural support. An OHP film may be or comprise a transparent film. In specific examples, OHP film may be one commonly used with an overhead projector. The base element may be made of a material providing sufficient strength for structural stability. The base layer may be made of a material providing sufficient strength for structural stability. The OHP film may be made of a material providing sufficient strength for structural stability. "Strength" may refer e.g. to one or more of tensile strength, flexural strength, torsional strength.

It may be provided that an adhesive may be arranged between the base element and the electrically conducting element. An adhesive may be arranged between the base layer and the electrically conducting element. An adhesive may be arranged between the OHP film and the electrically conducting element. The adhesive may be or may comprise an adhesive layer and/or adhesive film. The electrically conducting element may be attached to the base element by the adhesive.

The electrically conducting element may allow the passage of electrical current. The electrically conducting element may be made of or may comprise a conductive material, such as e.g. copper. For example, an electrically conducting element may comprise a copper strip. The electrically conducting element may may comprise a copper foil. Alternatively or additionally, the electrically conducting element may be made of or may comprise a conductive plastic. Alternatively or additionally, the electrically conducting element may be made of or may comprise a conductive polymer. For example, an electrically conducting element may comprise a conductive adhesive. The electrically conducting element may be or may comprise a film and/or a layer. The sensing spacer may allow for an easy and uncomplicated determination of the open circuit voltage of an individual electrode. The sensing spacer may be easily inserted into a battery module and/or a battery cell. The sensing spacer may be easily inserted between a separator and an exposed electrode. Alternatively or additionally, the sensing spacer may be inserted between a separator and an exposed tab.

A battery module may refer to a battery unit having at least one battery cell. A battery module may refer to a battery unit having a plurality of battery cells. A battery module may refer to a set of battery cells. A battery module may comprise a battery packaging for enclosing battery cells. A battery module may comprise multiple battery cells arranged in a specific configuration. For example, a battery module may be used in electric vehicles or consumer electronics.

The battery module may be or may comprise a pouch battery module. The battery cell may be or may comprise a pouch battery cell. A battery pouch module may mean a type of battery packaging where cells are enclosed in a flexible, foil-like pouch.

However, the present disclosure is not necessarily limited thereto. Alternatively or additionally, the battery module may be or may comprise a prismatic battery module and/or a cylindrical battery module. Alternatively or additionally, the battery cell may be or may comprise a prismatic battery cell and/or a cylindrical battery cell. The sensing spacer may not necessarily be limited to a specific type or kind of battery module and/or battery cell.

A battery cell may be or may comprise a single electrochemical cell capable of storing electrical energy. A battery cell may be or may comprise a mono cell. A battery cell may comprise one or more of various types of cells such as lithium-ion, nickel-metal hydride, or lead-acid cells. For example, a battery cell may be or may comprise a lithium-ion battery cell, as e.g. used in electrical vehicles or consumer electronics. A battery cell may be or may comprise a primary battery cell. A battery cell may be or may comprise a secondary battery cell.

A battery cell may comprise a positive electrode. A battery cell may comprise a negative electrode. A battery cell may comprise a separator. At least one electrode of the battery cell may be or may comprise a cathode. At least one electrode of the battery cell may be or may comprise an anode. A battery cell may comprise an electrolyte.

A separator may comprise a material that electrically isolates the electrodes within a battery cell while allowing ionic conductivity. In some examples, a separator may include microporous membranes made from polymers like polyethylene or polypropylene.

An electrode may be or may comprise a conductive component within a battery cell that may facilitate the flow of electrical current. An electrode may be or may comprise a cathode. An electrode may be or may comprise an anode. For example, an electrode may be or may comprise a graphite anode. For example, an electrode may be or may comprise a lithium cobalt oxide cathode.

For example, an electrode configured to act as an anode may be provided with an active material layer configured for receiving and/or storing, preferably releasably storing, ions. An active material, in particular of an anode, may include graphite as its main component. An electrode configured to act as a cathode may be equipped with an active material configured to release ions. The active material, in particular for a cathode, may comprise or consist of metal oxide, such as a lithium oxide. The active material may for example include or consist of LCO (LiCoO₂), NCM (Li(NiCoMn)O₂), NCA (Li(NiCoAl)O₂), LMO (LiMn₂O) and/or LFP (LiFePO₄). The active material may include conductive additives, binder, filler and other components (active material mixture). An active cathode material may be configured to be replenishable. The process of releasing ions from the cathode active material and received of ions by the anode active material may be referred to as discharging. A process of releasing ions from an anode active material and replenishing the cathode active material with the ion may commonly be referred to as charging or recharging. The active materials used in the electrodes of a battery are considered essential for determining properties of a battery such as its capacity, voltage and memory effect.

An electrode may comprise one or more tabs. A tab may extend from a side and/or face of an electrode. A tab may be or may comprise an extension of an electrode that may provide an external electrical connection. A tab may comprise a metal strip and/or a foil. For example, a tab may be or may comprise an aluminum tab connected to a cathode and/or anode.

The sensing spacer may allow to determine the open circuit voltage of an electrode in a in real-time. This may allow for the rapid identification of electrodes with abnormal voltage drops, thereby significantly reducing the time required for low voltage analysis from days to minutes or hours.

The sensing spacer may have rounded corners. The base element may have rounded corners. The base layer may have rounded corners. The OHP film may have rounded corners. The rounded corners may reduce the risk of damage to the separator and/or electrode during insertion.

The sensing spacer may be part of a system according to an aspect of the invention. The sensing spacer may be used when carrying out a method according to an aspect of the invention.

According to an exemplary embodiment, the sensing spacer may comprise a wire for connecting the sensing spacer to a detecting unit. The wire may be or may comprise an insulated wire. The wire may be electrically coupled to the electrically conducting element. The wire may serve as a conduit for electrical signals. The wire may enable the transmission of data and/or electrical impulses from the electrically conducting element of the sensing spacer to a detecting unit.

The insulated wire may be or may comprise a wire that may be covered with a non-conductive material. The non-conductive material may prevent electrical contact with other conductive materials. The non-conductive material may comprise materials such as e.g. plastic, rubber, or other insulating substances. The detecting unit may be or may comprise a device or system designed to receive and process signals from sensors or other input devices, such as sensing spacers. The detecting unit may comprise components such as one or more of a CPU microcontroller, signal processor, or display units. Specific examples may include a voltmeter, an oscilloscope, and/or a data acquisition system.

According to an exemplary embodiment, the surface area of the electrically conducting element may be smaller than the surface area of the base element. The ratio of the surface area of the electrically conducting element to the surface area of the base element may be between 0.3 to 0.9. Alternatively or additionally, the ratio of the surface area of the electrically conducting element to the surface area of the base element may be between 0.5 and 0.75. Alternatively or additionally, the ratio of the surface area of the electrically conducting element to the surface area of the base element may be around 0.6. The specific ratio of surface areas may ensure that the contact efficiency between the electrically conducting element and the electrode may be optimized while ensuring that the base element may provide sufficient structural support. The smaller surface area of the electrically conducting element relative to the base element may enhance the precision of the electrical contact, potentially reducing electrical resistance and improving the overall performance of the sensing spacer. Additionally, this configuration may facilitate the manufacturing process by allowing for easier alignment and placement of the electrically conducting element on the base element. The specific ratios provided may offer a range of design flexibility, allowing for adjustments based on the specific requirements of the application, such as e.g. the type of electrode being contacted or the environmental conditions in which the sensing spacer will operate. Further, the durability and longevity of the sensing spacer may be increased by ensuring that the electrically conducting element is adequately supported and protected by the base element.

The surface area may mean or refer to the total area covered by the electrically conducting element or the base element. The surface area may mean or refer to the total area as viewed from a top view. The ratio of the respective surface areas may mean or may refer to the proportional relationship between the surface area of the electrically conducting element and the surface area of the base element. For instance, a ratio of 0.6 may mean that the surface area of the electrically conducting element is 60% of the surface area of the base element.

The base element may be substantially plate-shaped and/or substantially flat. The electrically conducting element may be substantially plate-shaped and/or substantially flat. The surface area of the base element may be between 40mm x 40 mm and 80 mm x 80 mm. Alternatively or additionally, the surface area of the base element may be around 60 mm x 50 mm. Alternatively or additionally, The surface area of the electrically conducting element may be between 30 mm x 30 mm and 60 mm x 60 mm. Alternatively or additionally, the surface area of the electrically conducting element may be around 45 mm x 40 mm.

According to an exemplary embodiment, the sensing spacer may comprise another electrically conducting element configured to contact an electrode. The another electrically conducting element may be configured to contact a tab of an electrode. The another electrically conducting element may be arranged on a side of the base element opposite the electrically conducting element. The base element may provide structural support and insulation between the two electrically conducting elements. By having another electrically conducting element arranged on a side of the base element opposite the electrically conducting element, a simultaneous electrical contact with electrodes on both sides of the sensing spacer may be provided. Thereby, the efficiency and reliability of the sensing mechanism may be improved. The another electrically conducting element may mirror the function of the electrically conducting element but on the opposite side, thereby enabling a more versatile and robust electrical interface. The presence of two electrically conducting elements on opposite sides of the base element may also provide redundancy. For instance, functionality may be maintained in the event of a failure or degradation of one of the conducting elements.

The another electrically conducting element may be capable of transmitting electrical signals. The another electrically conducting element may comprise materials such as metals (e.g., copper, aluminum) or conductive polymers. The opposite side may be a side of the base element that is directly across from the side where the electrically conducting element may be arranged. The opposite side may refer to the other surface or face of the base element. The two electrically conducting elements may be on different planes relative to the base element.

An aspect of the invention relates to a system for determining whether a battery cell of a battery module to be tested has an abnormal voltage drop. The system may comprise a plurality of sensing spacers. Each sensing spacer may have an electrically conducting element. The electrically conducting element may be configured to contact an exposed electrode of a battery cell of the battery module to be tested. The electrically conducting element may be configured to contact an exposed tab of an electrode of a battery cell of the battery module to be tested. The system may comprise a detecting unit. The detecting unit may be configured to be electrically connected via the respective sensing spacers to electrodes of the battery module to be tested. The detecting unit may be configured to determine open circuit voltages of the electrodes and/or battery cells of the battery module to be tested. The detecting unit may be configured to determine open circuit voltages of the electrodes and/or battery cells of the battery module to be tested at multiple time steps. The system may comprise a computing unit. The computing unit may be configured to determine whether a battery cell of the battery module to be tested has an abnormal voltage drop based on the determined open circuit voltages.

"System" may mean or refer to a combination of components designed to function together to achieve a specific purpose. For example, the system may comprise hardware and software components working together to monitor battery cells.

The computing unit may be or may comprise a device or system that may process data and perform calculations. For example, the computing unit may be or may comprise a microcontroller or computer running software to analyze open circuit voltage data.

The system may comprise at least one sensing spacer according to an aspect of the invention. At least one, several or all sensing spacers of the system may be or may comprise sensing spacer according to an aspect of the invention.

The system may be used to carry out a method according to an aspect of the invention. At least one, several or all steps of a method according to an aspect of the invention may be carried out by or with the system.

According to an exemplary embodiment, the system may further comprise a pressing unit. The pressing unit may be configured for applying a pressure onto the battery module when determining the open circuit voltages. The pressing unit may enhance the accuracy and reliability of the open circuit voltage measurement by ensuring consistent contact between the sensing spacers and the exposed electrodes, and/or exposed tabs, of the battery cells. The pressing unit may minimize the potential for variations in the electrical connection that could otherwise lead to erroneous determinations of open circuit voltages. The pressing unit may operate through various mechanisms, such as mechanical, pneumatic, or hydraulic means. The pressing unit may be configured to apply a uniform pressure across the entire surface of the battery module. By doing so, it may be ensured that all battery cells within the battery module may be subjected to the same testing conditions, thereby improving the overall reliability of the open circuit voltage determination process. Additionally, the pressing unit may be designed to apply a specific amount of pressure that is optimal for the type of battery cells being tested, which can vary depending on the material and construction of the cells. This feature may be particularly beneficial for battery modules which have flexible and sometimes irregular shapes that can make consistent electrical contact challenging. The pressing unit's ability to apply pressure uniformly may help to mitigate these challenges, ensuring that the sensing spacers can maintain a stable and reliable connection with the electrodes throughout the testing process. This, in turn, may allow the detecting unit to determine the open circuit voltages more accurately at multiple time steps, which may then be used by the computing unit to determine whether any battery cell has an abnormal voltage drop.

For example, a mechanical pressing unit may use a screw mechanism to apply pressure. For example, a pneumatic pressing unit may use an air cylinder to apply pressure.

According to an exemplary embodiment, the system may be configured to determine open circuit voltages in real time. Alternative or additionally, the system may be configured to determine whether a battery cell of the battery module to be tested has an abnormal voltage drop in real time. The real-time determination of open circuit voltages may allow for instantaneous data acquisition and processing. The sensing spacers, equipped with electrically conducting elements, may contact the exposed electrodes, and/or exposed tabs, of the battery cells and relay voltage data to the detecting unit. The detecting unit, in turn, may be configured to determine the open circuit voltages at multiple time steps and transmit this data to the computing unit. The computing unit may process the received voltage data in real time to determine if there is an abnormal voltage drop.

An aspect of the invention relates to a method for determining whether a battery cell of a battery module has an abnormal voltage drop. The method may include a step of exposing electrodes of battery cells of the battery module. The method may include a step of contacting the exposed electrodes with sensing spacers, such that each contacted electrode is contacted by an electrically conducting element of a respective sensing spacer. The method may include a step of determining, at multiple time steps, open circuit voltages of the electrodes and/or battery cells with the sensing spacers contacting the exposed electrodes. The method may include a step of determining whether a battery cell has an abnormal voltage drop based on the determined open circuit voltages.

An electrode may have a tab. Exposing electrodes may comprise or consist of exposing tabs of the electrodes of the battery module. When exposing an electrode, a tab of the electrode may be exposed.

Contacting the exposed electrodes may comprise contacting the tabs of the electrodes. It may be provided that the method includes contacting the exposed tabs with sensing spacers, such that each contacted tab is contacted by an electrically conducting element of a respective sensing spacer. Contacting may mean a physical contact. Contacting may mean a direct contact. Contacting may mean an electrical contact.

It may be provided that the open circuit voltage is determined with the sensing spacers contacting the exposed tabs of the respective electrodes. The sensing spacer and/or the electrically conducting element may be in direct contact with an electrode. The sensing spacer and/or the electrically conducting element may be in electrical contact with an electrode. The sensing spacer and/or the electrically conducting element may be in direct contact with a tab. The sensing spacer and/or the electrically conducting element may be in electrical contact with a tab.

In a particular example, the method may comprise the steps: exposing tabs of the electrodes of battery cells of the battery module; contacting the exposed tabs with sensing spacers, such that each contacted tab is contacted by an electrically conducting element of a respective sensing spacer; determining, at multiple time steps, open circuit voltages of the electrodes and/or battery cells with the sensing spacers contacting the exposed tabs of the respective electrodes; and determining whether a battery cell has an abnormal voltage drop based on the determined open circuit voltages of the electrodes.

Determining that a battery cell has an abnormal voltage drop may include determining that the battery cell is defective and/or impaired. Determining that a battery cell has an abnormal voltage drop may include determining that an electrode of the battery cell is defective and/or impaired. Alternatively or additionally, after determining that a battery cell has an abnormal voltage drop, it may be provided to carry out a diagnosis of the battery cell, and/or to identify defects or faults of the battery cell. Alternatively or additionally, after determining that a battery cell has an abnormal voltage drop, it may be provided to carry out a diagnosis of the electrodes of the battery cell, and/or to identify defects or faults of the electrodes of the battery cell.

The method may allow for real-time monitoring of the electrical properties of electrodes and/or battery cells within the battery module. By being contacted with the sensing spacers, the open circuit voltage can be can accurately determined. In particular, contact, e.g. direct contact, between the sensing spacers and the electrodes or tabs may ensure that the open circuit voltages may be precise and reliable determined.

The method may be carried out at least partially or fully automatically. Alternatively or additionally, the method may be carried out at least partially or fully without manual labor.

The method may be carried out quickly. The method may be carried out and/or be completed in minutes. The method may be carried out and/or be completed in up to a few hours.

A battery module may mean a type of battery packaging where cells are enclosed. A battery pouch module may mean a type of battery packaging where cells are enclosed in a flexible, foil-like pouch. A battery module may comprise multiple battery cells arranged in a specific configuration. For example, a battery module may be used in electric vehicles or consumer electronics.

"Open circuit voltage (OCV)" may mean or refer to a voltage of a battery cell and/or of an electrode when it is not connected to any external circuit and/or load. For instance, open circuit voltage may represent the maximum potential difference that a battery cell can provide under these conditions. Alternatively or additionally, open circuit voltage may represent the maximum potential difference when no current is flowing. It may be provided that the open circuit voltage of a battery cell may be or may comprise a potential difference between a positive and a negative terminal of the battery cell. The open circuit voltage of a battery cell may be or may comprise a potential difference between an anode and cathode of the battery cell. It may be provided that the open circuit voltage of an electrode may be or may comprise a potential difference between an electrode and a reference electrode.

For instance, the open circuit voltage of battery cell may be determined by measuring the voltage across the terminals of the battery cell when it is not connected to any external load. This voltage may reflect the electrochemical potential of the battery cell. The open circuit voltage can vary based on factors like the chemistry of the battery cell, its temperature, and/or whether it is damaged or impaired. Open circuit voltage may be a key parameter for assessing the performance and capacity of a battery cell.

The open circuit voltage of a battery cell and/or an electrode may be determined by comparing a potential of the electrode to the potential of another electrode. For instance, the potential of an anode of a battery cell may be compared to the potential of a cathode of the battery cell, or vice versa.

Determining an open circuit voltage of a battery cell may comprise determining an open circuit voltage of an electrode. Determining an open circuit voltage of an electrode may comprise determining an open circuit voltage of a battery cell. An open circuit voltage of an electrode may be or may comprise an open circuit voltage of a battery cell. In some examples, the open circuit voltage of the battery cell may be the same as the open circuit voltage of an electrode of the battery cell, and/or the open circuit voltage of the battery cell may comprise the open circuit voltage of an electrode of the battery cell. However, in some examples, the open circuit voltage of the battery cell may be different from the open circuit voltage of an electrode of the battery cell. For instance, the open circuit voltage of the electrode may be determined by comparing the potential of the electrode to the potential of a reference electrode, which may or may not be part of the battery cell.

"Abnormal voltage drop" may mean or refer to a comprise sudden drop or a gradual declines of a determined open circuit voltage. A drop and/or decline may mean a decrease over time. An abnormal voltage drop of a battery cell and/or electrode may imply or result from a defect of the battery cell and/or electrode.

"Multiple time steps" may mean or refer to different points in time at which measurements are taken. For example, open circuit voltage measurements may be taken every minute over a three-hour period, and/or the open circuit voltage may be determined every minute over a three-hour period. The time difference between two consecutive time steps may be between a few milliseconds up to a several minutes. For example, the time difference between two consecutive time steps may be between 0.1 seconds and 1 minute. For example, the time difference between two consecutive time steps maybe between 0.25 seconds and 15 seconds. For example, the time difference between two consecutive time steps may be 0.5 seconds, or substantially 0.5 seconds.

"Determining" may include one or more of measuring, sensing, quantifying, gauging, metering, detecting, capturing, registering, recording, storing, and the like, for example, without being exhaustive. "Determining" may include taking and/or performing a measurement. Suitable devices and/or methods may be employed and/or used, as understood by the person skilled in the art.

It may be provided that at least one, several or all steps of the method may be computer-implemented.

According to an exemplary embodiment, the method may further comprise applying a pressure onto the battery module when determining the open circuit voltages. By applying pressure onto the battery module, the method may ensure that the sensing spacers may maintain consistent and reliable contact with the exposed electrodes or tabs of the battery cells. This applied pressure can help in mitigating any potential issues arising from poor contact or misalignment, which could otherwise lead to inaccurate voltage readings and/or inaccurate determination of open circuit voltages. The pressure may be applied using various means, such as mechanical clamps, pneumatic systems, or other pressure-applying devices, ensuring that the contact between the sensing spacers and the electrodes and/or tabs is firm and stable throughout the voltage measurement process. Thereby, the accuracy and reliability of the voltage determination may be enhanced, and the overall effectiveness of the method may be improved.

Applying a pressure may mean or refer to applying a force onto the battery module. Specific examples may include mechanical clamps, pneumatic systems, or hydraulic presses.

According to an exemplary embodiment, when determining the open circuit voltages, all time steps of the multiple time steps may be in a time interval of between 1 minute and 3 hours. It may be provided that the determination of the open circuit voltages may occur at multiple time steps, all of which may be confined within a time interval ranging from 1 minute to 3 hours. Thus, the open circuit voltages may be determined within a defined and relatively short period. The method according to the invention may be carried out much quicker than known methods from the prior art.

A time interval may comprise the total duration within which all measurements of open circuit voltages are taken, and/or the total duration within which all open circuit voltages are determined. Specific examples may include a continuous period starting from a first measurement and ending at a last measurement within a specified range of 1 minute to 3 hours.

According to an exemplary embodiment, determining the open circuit voltages may be carried out in real time. Alternatively and/or additionally, determining whether a battery cell has an abnormal voltage drop may be carried out in real time. By enabling real-time determination, the method may allow for immediate detection of any abnormal voltage drops. The real-time aspect ensures that any deviations in voltage are promptly identified. The real-time determination capability may also be integrated with other systems, such as alert mechanisms or automated control systems.

"Real-time" may mean or refer to a capability of processing data and/or providing results instantaneously or with minimal delay. Specific examples may include systems that update voltage measurements and diagnostic results within milliseconds or seconds.

According to an exemplary embodiment, the method may include transforming the determined open circuit voltages relative to each other. This transformation process may involve comparing the open circuit voltages of different battery cells to identify any deviations or anomalies that may indicate an abnormal voltage drop. By transforming the voltages relative to each other, the method may allow for a more precise and contextual analysis of the battery cells' performance. Furthermore, it may be provided that small differences between battery cells may be more easily identified and/or spotted, and/or that small differences may be enlarged. This comparative approach can help in identifying specific cells that are underperforming or experiencing issues. The transformation may involve mathematical operations such as normalization, averaging, or differential analysis, which can highlight discrepancies between the cells' voltages. Further, the accuracy of the abnormal voltage drop detection can be improved by considering the relative performance of each cell within the module, rather than relying solely on absolute open circuit voltage values. The method may thus provide a robust mechanism for determining whether a battery cell has an abnormal voltage drop and/or whether a battery cell is impaired. By incorporating a transformation step, the method may leverage comparative data to deliver more insightful diagnostics.

"Transforming" may mean or refer to altering or converting the determined open circuit voltages into a different form or representation for analysis purposes. Specific examples may include mathematical transformations such as normalization, averaging, or calculating differences between voltages.

According to an exemplary embodiment, the method may further comprise a step of for each time step and contacted electrode, summing the respective open circuit voltage as determined up to and including the time step, such that a cumulated sum of the open circuit voltage for each respective electrode and/or respective battery cell is obtained. The method may comprise a step of for each time step, calculating a mean open circuit voltage from the cumulated sums. The method may comprise a step of for each time step and cumulative sum, calculating the difference between the respective cumulated sum and the mean open circuit voltage. The method may comprise a step of if the difference is decreasing with time, determine that the battery cell which comprises the decreasing difference has an abnormal voltage drop.

One or more of the steps of calculating a cumulated sum, calculating a mean open circuit voltage and/or calculating a difference may be an example of a transformation of the determined open circuit voltages relative to each other. However, transforming determined open circuit voltages relative to each other is not limited to these steps, and/or may include other, additional or different steps. Transformed open circuit voltages may comprise, be or correspond to the calculated differences, and/or vice versa.

The cumulated sum may represent an aggregate voltage measurement over time. A cumulated sum may comprise a total accumulated value of open circuit voltages determined over multiple time steps. A cumulated sum may be or may comprise a running total. For example, if the open circuit voltage is determined at three different time steps as 3.7V, 3.6V, and 3.5V, the cumulated sum at the third time step may be 10.8V Thus, a more comprehensive dataset for analysis may be provided.

A cumulative sum may be associated with a battery cell and/or an electrode. A cumulative sum may be associated with the battery cell and/or the electrode based on which open circuit voltage the cumulated sum is calculated.

The mean open circuit voltage may comprise an average value of the cumulated sums of all electrodes at a given time step. For instance, if there are three electrodes with cumulated sums of 10.8V, 11.0V, and 10.5V, the mean open circuit voltage may be 10.76V. The mean open circuit voltage may serve as a reference point for comparing individual electrode performance.

The difference may comprise a numerical value obtained by subtracting the mean open circuit voltage from the cumulated sum of a specific electrode. For example, if the cumulated sum of an electrode is 10.8V and the mean open circuit voltage is 10.76V, the difference may be 0.04V. It may be provided that the difference may comprise an absolute value of a numerical value obtained by subtracting the mean open circuit voltage from the cumulated sum of a specific electrode. The difference may quantify the deviation of each electrode's performance from the average performance of all electrodes.

A decreasing difference may comprise a trend where the difference value reduces over successive time steps, indicating a relative decline in the electrode's performance. For example, if the difference values for an electrode at three consecutive time steps are 0.04V, 0.03V, and 0.02V, this trend may indicate a decreasing difference. A decreasing difference with time may indicate an electrode that is underperforming relative to the other electrodes. Thereby, a battery cells with potential issues may be identified.

According to an exemplary embodiment, the method may further comprise determining a trend line of the difference to determine if the difference is decreasing with time. Determining a trend line may involve the analysis of the difference in open circuit voltages over multiple time steps. By determining a trend line, the method may allow for the monitoring of open circuit voltage behavior over time, providing a more dynamic and temporal understanding of a battery cell's performance. Determining the trend line can help identify patterns or anomalies in the open circuit voltage that may not be apparent from a single measurement or a simple comparison of values. The trend line can be determined using various statistical or mathematical techniques, such as linear regression or moving averages, to provide a clear and interpretable representation of the difference of the respective cumulated sums and the mean open circuit voltage over time. By incorporating the trend analysis, it may be provided that the method may not only detect abnormal voltage drops but also provide insights into the underlying causes and potential remedies. Overall, the inclusion of trend line may offer a more comprehensive and predictive approach to battery health assessment.

A trend line may comprise a representation of data points in a time series that shows the general direction or pattern of the data. A trend line may comprise various forms such as linear, exponential, or polynomial trend lines. For example, a trend line may show a steady increase or decrease in the difference of the respective cumulated sum and the mean open circuit voltage over time.

A "decrease with time" may mean or refer to a trend where the differences show a reduction over successive time steps. For instance. A decrease with time may comprise a downward slope in the trend line, and/or a negative slope of the trend line. For example, if the voltage difference decreases from 0.1V to 0.05V over several time steps, it may indicate a decreasing trend with time.

It may be provided that a decrease with time may comprise a monotonic decrease, such as e.g. a monotonic decrease of the trend line.

According to an exemplary embodiment, contacting the exposed electrodes with sensing spacers may involve inserting a respective sensing spacer between an electrode and a separator of at least one or all battery cells of the battery module. Alternatively or additionally, contacting the exposed tabs with sensing spacers may involve inserting a respective sensing spacer between an electrode and a separator of at least one or all battery cells of the battery module. It may be provided that the sensing spacer may be strategically positioned to make precise contact with the electrodes, thereby enhancing the accuracy and reliability of the determination of the open circuit voltage. By inserting the sensing spacer between the electrode and the separator, and/or between the tab and the separator, it may be ensured that the electrically conducting element of the sensing spacer is in optimal contact with the electrode, which may reduce the likelihood of measurement errors that could arise from poor contact or external interferences. This positioning may also facilitate a more consistent and stable connection, which is crucial for obtaining accurate determination of open circuit voltages over multiple time steps. Overall, this may enhance the robustness and reliability of the method for detecting abnormal voltage drops in battery cells by improving the contact quality between the sensing spacers and the electrodes, and/or between the sensing spacers and the tabs.

According to an exemplary embodiment, it may be provided that when or after contacting the exposed electrodes with sensing spacers, the respective electrodes may be at least partially insulated by the respective sensing spacer. When or after contacting the exposed electrodes with sensing spacers, the respective electrodes may be at least partially insulated by a base element of the sensing spacer. Alternatively or additionally, it may be provided that when or after contacting the exposed tabs with sensing spacers, the respective electrodes may be at least partially insulated by the respective sensing spacer, preferably by a base element of the sensing spacer. The at least partial insulation provided by the sensing spacer, e.g. by its base element, may ensure that the electrodes may be protected from external electrical interference and potential short circuits. This insulation mechanism may enhance the reliability and accuracy when determining the open circuit voltages. By insulating the electrodes, the method may minimize the risk of erroneous readings caused by external factors, thereby improving the overall diagnostic capability of the system. The base element of the sensing spacer, which may provide the insulation, may be made of materials such as rubber, plastic, or other non-conductive substances that are capable of effectively isolating the electrodes from their surroundings. This may ensure or at least facilitate that the voltage readings may be solely influenced by the intrinsic properties of the battery cells and not by external electrical noise or interference.

"Insulated" may mean or refer to being protected or shielded from electrical interference or contact with other conductive materials. The base element may be or may comprise a foundational part of the sensing spacer that may provide structural support. The base element may provide insulation. The base element may be electrically non-conductive. Specific examples may include a rubber base, a plastic base, or any other non-conductive material designed to isolate the electrodes. The base element may be or may comprise an OHP film.

Further, an automated battery manufacturing system is disclosed. The automated battery manufacturing system may be configured to assembly a battery module and/or a battery pack, such as a battery module and/or battery pack. The automated battery manufacturing system may comprise devices, units, machines, tools and/or other devices for assembling a battery module and/or a battery pack. For instance, the automated battery manufacturing system may be configured to assemble a battery module from battery cells. For instance, the automated battery manufacturing system may be configured to assemble a battery pack from one or more battery modules. The battery module and/or battery pack may be assembled according to a given specification, and the automated battery manufacturing system may be configured accordingly. The term "automated battery manufacturing system" may be used herein as commonly understood in the field of battery manufacturing.

Further, an automated plant is disclosed. The automated plant may comprise the automated battery manufacturing system as disclosed herein. The examples and optional features of the automated manufacturing system as disclosed herein may also apply to the automated plant, and/or vice versa.

The automated plant may be or may include a smart factory, in which the automated battery manufacturing system may be implemented. The examples and optional features of the automated manufacturing system as disclosed herein may also apply to the smart factory, and/or vice versa. The term "smart factory" may be used herein as commonly understood in the field of industrial processing, particularly in the fields of automation, Internet of Things, artificial intelligence, big data analytics, cloud computing and robotics. In particular, the smart factory may be understood in connection with the Industry 4.0 paradigm. The smart factory as used herein may also be referred to as a digital factory or intelligent factory, and may indicate an advanced manufacturing facility that utilizes various digital technologies, automation, and data exchange in production processes.

Further, an automated battery manufacturing method is disclosed. The automated battery manufacturing method, also shortly referred to herein as a "battery manufacturing method" or "method", may comprise the steps for manufacturing a battery cell. Alternatively or additionally, the automated battery manufacturing method may comprise steps for manufacturing and/or assembling a battery module. Alternatively or additionally, the automated battery manufacturing method may comprise steps for manufacturing and/or assembling a battery pack. The automated battery manufacturing method may comprise all required steps, as understood by the skilled person. However, the automated battery manufacturing method may not necessarily be limited thereto.

The method may be facilitate an integration of a battery manufacturing process into an automated plant, such as a smart factory. Furthermore, the system and the method disclosed herein may facilitate automation of battery manufacturing, thereby reducing cost, time and energy required.

The automated battery manufacturing system may be capable of carrying out the automated battery manufacturing method as disclosed herein. Furthermore, the automated battery manufacturing system may be capable of carrying out any, some or all of the steps of the automated battery manufacturing method disclosed herein. The automated battery manufacturing method may be implemented to be carried out in the automated battery manufacturing system as disclosed herein.

It may be provided that the automated battery manufacturing method may include or comprise a method according to an aspect of the invention. Alternatively or additionally, it may be provided that after having manufactured a battery module by or with the automated battery manufacturing method, the automated battery manufacturing system and/or the automated plant, the battery module may be diagnosed, checked and/or tested with a method according to an aspect of the invention. In particular, after having manufactured a battery module with or by the automated battery manufacturing method, the automated battery manufacturing system and/or the automated plant, it may be provided to determine whether a battery cell of the battery module has an abnormal voltage drop.

It may be provided the automated battery manufacturing system and/or the automated plant may comprise at least one sensing spacer according to an aspect of the invention. Alternatively or additionally, It may be provided the automated battery manufacturing system and/or the automated plant may comprise the system according to an aspect of the invention.

### BRIEF DESCRIPTION OF THE DRAWINGS

Examples of the invention are further described with reference to the following figures:
- Figure 1:: shows a schematic flowchart of an exemplary method for determining whether a battery cell has an abnormal voltage drop;
- Figure 2a:: shows an exemplary embodiment of a battery module with exposed tabs;
- Figure 2b:: shows an exemplary embodiment of a battery module with sensing spacers;
- Figure 3:: shows an exemplary embodiment of a sensing spacer contacting the electrodes and tabs of battery cells in a battery module;
- Figure 4:: shows another exemplary embodiment of a sensing spacers contacting electrodes and tabs of battery cells in a battery module;
- Figure 5:: shows an exemplary embodiment of a battery module with sensing spacers and a detecting unit;
- Figure 6a:: shows a graph of open circuit voltages over time;
- Figure 6b:: shows a graph of transformed open circuit voltages over time;
- Figure 7:: shows a schematic flowchart of steps an exemplary method for determining whether a battery cell has an abnormal voltage drop;
- Figure 8a:: shows an exemplary table of open circuit voltages over time;
- Figure 8b:: shows an exemplary table of cumulated sums of the open circuit voltages of the table in fig. 8a and mean open circuit voltages;
- Figure 8c:: shows an exemplary table of differences between cumulated sums and mean open circuit voltages of the table in fig. 8b;
- Figure 9a:: shows a graph of the open circuit voltages of the table of fig. 8a;
- Figure 9b:: shows the transformed open circuit voltages of the table of fig. 8c and a trend line;
- Figure 10a:: shows an exemplary embodiment of a sensing spacer with a base element and an electrically conducting element;
- Figure 10b:: shows a cross-sectional view of another exemplary embodiment of a sensing spacer;
- Figure 10c:: shows another embodiment of a sensing spacer;
- Figure 11:: shows an exemplary embodiment of a system for determining whether a battery cell of a battery module has an abnormal voltage drop; and
- Figure 12:: shows exemplary detailed of defects or abnormalities

### DETAILED DESCRIPTION OF PREFERRED EMBODIMENTS

For the purposes of promoting an understanding of the principles of the invention, reference will now be made to embodiments illustrated in the drawings, and specific language will be used to describe the same. It will nevertheless be understood that no limitation of the scope of the invention is thereby intended.

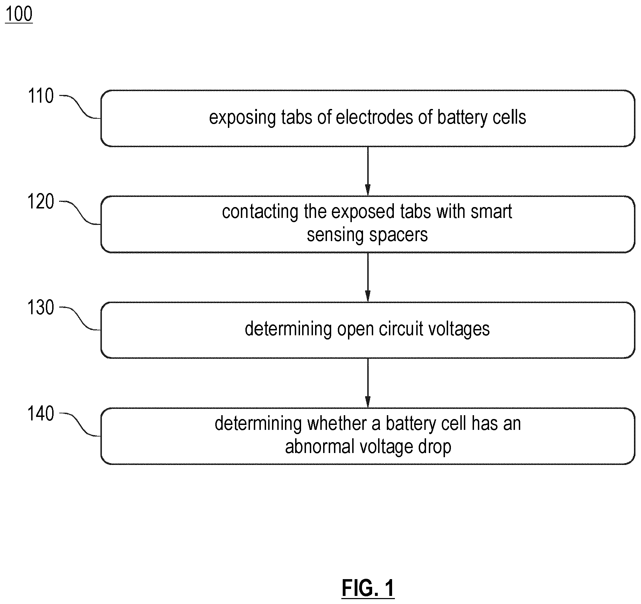

Figure 1 illustrates an exemplary method 100 for determining whether a battery cell of a battery module has an abnormal voltage drop. The battery cell may be or may comprise a pouch battery cell. The battery module may be or may comprise a pouch battery module. However, these are only exemplary, and the disclosure is not necessarily limited thereto.

The method 100 may comprise several steps, each of which is described in detail below.

In a step of the method 100, electrodes 212 of battery cells 210 of the battery module 200 are exposed. When exposing the electrodes 212, tabs 218 of the electrodes 212 may be exposed. The method 100 may comprise exposing tabs 218 of the electrodes 212 of the battery cells 210. For instance, step 110 may involve exposing tabs 218 of electrodes 212 of battery cells 210. Step 110 may include removing any covering or insulation that may be present on the tabs 218 to ensure they are accessible for subsequent operations. The exposed tabs 218 may be part of the electrodes 212 of the battery cells 210 within the battery module 200.

In a subsequent step, the method 100 comprises contacting the exposed electrodes 212 with sensing spacers 300, such that each contacted electrode 212 is contacted by an electrically conducting element 320, 340 of a respective sensing spacer 300. When contacting the exposed electrodes 212, exposed tabs 218 maybe contacted by respective sensing spacers 300. The method 100 may comprise contacting the exposed tabs 218 with sensing spacers 300, such that each contacted tab 218 is contacted by an electrically conducting element 320, 340 of a respective sensing spacer 300. For example, step 120 may involve contacting the exposed tabs 218 with sensing spacers 300. The sensing spacers 300 may be designed to have electrically conducting elements 320, 340 that can make contact with the exposed tabs 218. This contact may facilitate the measurement of electrical properties of battery cells 210, such as a determination of an open circuit voltage of an electrode 212. A sensing spacers 300 may be inserted between an electrode 212 and a separator 216 of the battery cells 212, ensuring a secure and reliable connection. Alternatively or additionally, the sensing spacer 300 may be inserted between a tab 218 and a separator 216 of the battery cells 212.

In a subsequent step, the method 100 comprises determining, at multiple time steps 270, open circuit voltages 220 of the electrodes 212 with the sensing spacers 300 contacting the exposed electrodes 212. The method 100 may comprise determining, at multiple time steps 270, open circuit voltages 220 of the electrodes 212 with the sensing spacers 300 contacting the exposed tabs 218 of the respective electrodes 212. For example, step 130 may involve determining open circuit voltages 220 of the electrodes 212. This step may be performed using the sensing spacers 300 that are in contact with the exposed tabs 218. The open circuit voltage 220 may be a voltage measured and/or determined across the electrodes 212 when no external load is connected, e.g. providing an indication of the battery cell's 210 state of charge and health. This determination may be carried out at multiple time steps 270 to monitor and/or determine the respective open circuit voltage 220 over a period.

The method 100 comprises determining whether a battery cell 210 has an abnormal voltage drop based on the determined open circuit voltages 220 of the electrodes 212. For example, step 140 may involve determining whether a battery cell 210 has an abnormal voltage drop. This determination may be based on the open circuit voltages 220 measured in step 130. An abnormal voltage drop may indicate issues such as internal short circuits, degradation, defects, or other faults within the battery cell 210. An abnormal voltage drop may indicate that a battery cell 210 may be impaired. The method 100 may include comparing the determined open circuit voltages 220 to expected values or trends to identify any deviations that suggest an abnormal condition. The method 100 may include transforming the transforming the determined open circuit voltages 220 relative to each other. The transformed open circuit voltages may then be used for detecting whether a battery cell 100 has an abnormal voltage drop.

Each of these steps may be performed in sequence to ensure accurate and reliable detection of abnormal voltage drops in battery cells. It may be provided that some steps may be repeated. The method 100 may be implemented in real-time, allowing for continuous monitoring and immediate detection of any issues.

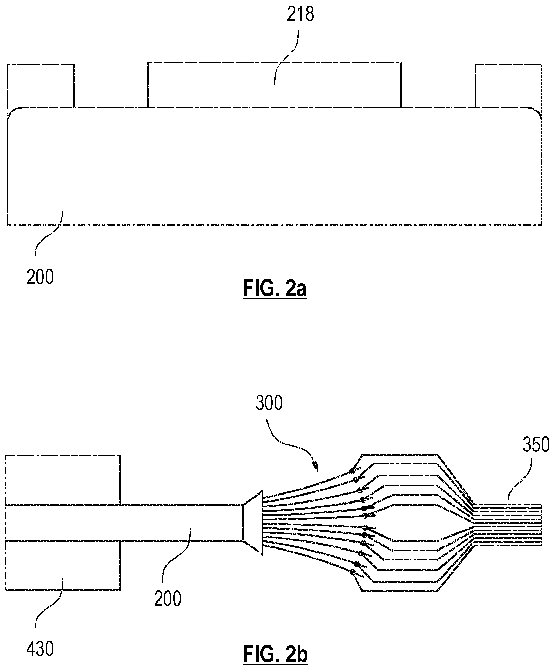

Figure 2a shows a battery module 200. The battery module 200 may comprise electrodes 212, which are not visible in figure 2a. Figure 2a illustrates an exposed tab 218 of an electrode 212. The exposed tab 218 may be made of a conductive material, such as copper. The tab 218 may be designed to facilitate electrical contact.

Figure 2b illustrates a more detailed view of the interaction between the battery module 200 and a sensing spacer 300. The sensing spacer 300 may be positioned to contact the exposed tab 218 of the electrode 212. The sensing spacer 300 may comprise an electrically conducting element 320, which is not visible in figure 2b. The sensing spacer 300 may also include a wire 350, such as e.g. an insulated wire 350. The wire 350 may be used to connect the sensing spacer 300 to a detecting unit 410, which is not shown in figure 2b.

Additionally, Figure 2b shows a pressing unit 430. The pressing unit 430 may be configured to apply pressure onto the battery module 200. This pressure application may ensure proper contact between the sensing spacer 300 and the exposed tab 218. The pressing unit 430 may be mechanical or pneumatic, depending on the specific requirements of the testing setup.

The sensing spacer 300 may be designed to partially insulate the electrode 212. This insulation may be provided by a base element 310, which is not visible in this figure 2b. The base element 310 may be made of an insulating material, such as an OHP film, to prevent short circuits and ensure accurate voltage measurements.

Multiple sensing spacers 300 may be inserted between respective electrodes 212 and separators 216, and/or between respective tabs 218 and separators 216. It may be provided that each sensing spacer 300 may be connected via a wire 350 to the detecting unit 410. The wires 350 may be color-coded or labeled for easy identification and connection to the detecting unit 410.

The detecting unit 410, although not shown in figure 2b, may be configured to measure open circuit voltages 220 of the electrodes 212 at multiple time steps 270. These measurements may be used to determine whether any battery cell 210 within the battery module 200 has an abnormal voltage drop. The detecting unit 410 may be connected to a computing unit 420 (not visible in figure 2b), which may analyze the determined open circuit voltages to identify any potential issues.

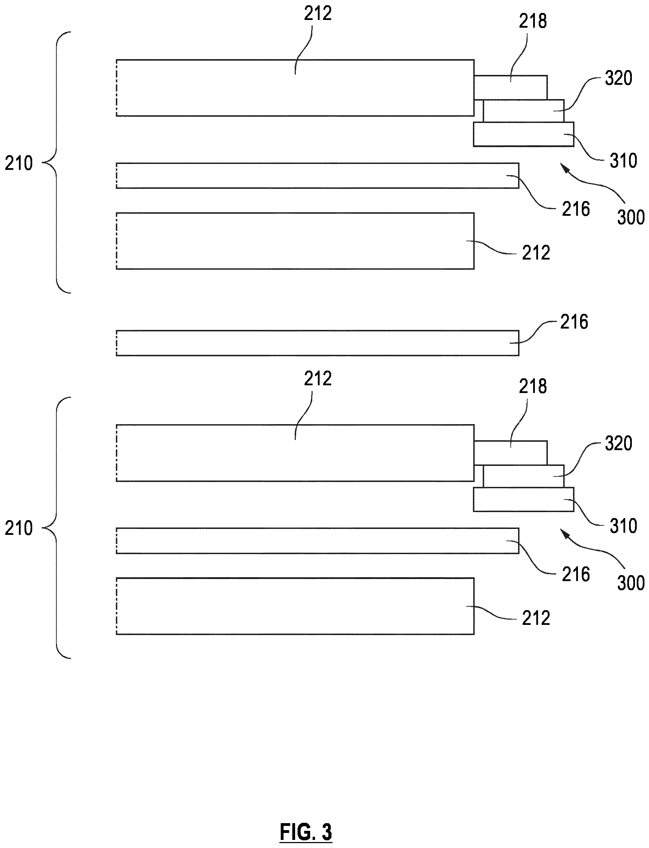

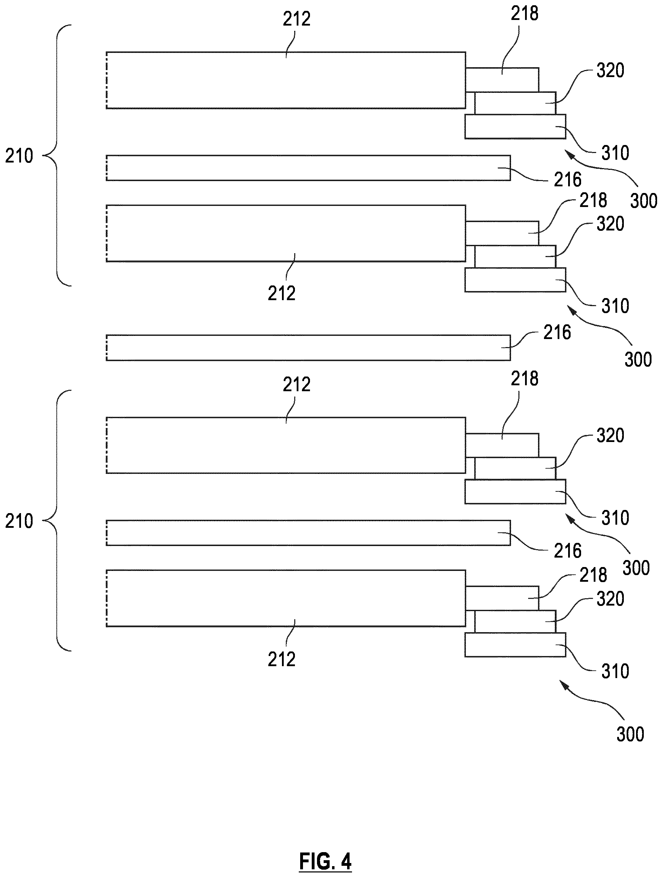

Figures 3 and 4 illustrate embodiments of a battery module 200 with sensing spacers 300. The battery module 200 may comprise multiple battery cells 210. Each battery cell 210 may include electrodes 212 and separators 216. The electrodes 212 may be exposed at their tabs 218. An electrode 212 may be an anode or a cathode. Each battery cell 210 may comprise at least one anode and at least one cathode. Between an anode and a cathode, a separator 216 may be arranged. Between two electrodes 212, a separator 216 may be arranged. An electrode 212 may comprise a tab 218. The tab 218 may extend from the electrode 212.

In Figure 3 and 4, only a part of the electrodes 212 and/or the separators 216 may be shown. It may be provided that the tabs 218 of some electrodes 212 may arranged on one side and/or end of the electrodes 212, and the tabs of the other electrodes 212 may be arranged on an opposite side and/or end. For instance, in figure 3, some tabs 218 may be shown on a right side in the figure, whereas tabs 218 of the other electrodes 212 may be arranged on a left side of the electrodes 212 (not shown in figure 3).

In some embodiments, the tabs 218 of the cathodes may be arranged on one side and/or end of the cathodes, and the tabs 218 of the anodes may be arranged on a side which is an opposite side and/or end relative the tabs of the cathodes.

Alternatively, it may be provided that the tabs 218 of all electrodes 212 may be arranged at the same side and/or end of the electrodes 212, cf. e.g. figure 4. In some embodiments, the tabs 218 of the cathodes may be arranged on one side and/or end of the cathodes, and the tabs 218 of the anodes may be arranged on a side which is the same side and/or end relative the tabs of the cathodes. For instance in figure 4, all tabs 218 may be arranged on the right side in the figure.

The sensing spacer 300 may include a base element 310. The base element 310 may comprise a base layer, which may be an OHP film. An electrically conducting element 320 may be arranged on the base element 310. The electrically conducting element 320 may be configured to contact an electrode 212, preferably the tab 218 of the electrode 212.

The sensing spacer 300 may be positioned between the electrode 212 and the separator 216 of the battery cell 210. The sensing spacer 300 may optionally insulate the respective electrode 212 at least partially. This insulation may be provided by the base element 310 of the sensing spacer 300.

The electrically conducting element 320 may have a surface area smaller than the surface area of the base element 310. The ratio of the surface area of the electrically conducting element 320 to the surface area of the base element 310 may be between 0.3 to 0.9, more preferably between 0.5 and 0.75, and even more preferably around 0.6.

The sensing spacer 300 may optionally include another electrically conducting element 340 (not shown in figure 3 and 4). The another electrically conducting element 340 may be configured to contact an electrode 212, preferably the tab 218 of the electrode 212. The another electrically conducting element 340 may be arranged on the side of the base element 310 opposite the electrically conducting element 320.

The sensing spacer 300 may also include a wire 350 (not shown in figure 3 and 4), e.g. an insulated wire. The wire 350 may connect the sensing spacer 300 to a detecting unit (not shown in figure 3). The wire 350 may be electrically coupled to the electrically conducting element 320.

The sensing spacers 300 may be used to determine open circuit voltages 220 of the electrodes 212. The sensing spacers 300 may contact the exposed tabs 218 of the electrodes 212. This contact may allow for the detection and measurement of the open circuit voltages.

The battery module 200 may be subjected to pressure during the determination of the open circuit voltages 220. This pressure application may enhance the accuracy of the voltage measurements.

It may be provided that a sensing spacer 300 may be inserted between an electrode 212 of a battery cell 210 and a separator 216, and another sensing spacer 300 may be inserted between another electrode 212 of the battery cell 210 and the separator 216. The sensing spacer 300 may contact the electrode 212, and the other sensing spacer 300 may contact the other electrode 212. Thereby, the open circuit voltage 220 may be determined, e.g. the open voltage circuit of the electrodes 212 and/or the battery cell 210. For instance, the electrode 212 may be or may comprise an anode 214 or a cathode 213, and the other electrode 212 may be or may comprise a cathode 213 and/or an anode 214.

Alternatively or additionally, it may be provided that a sensing spacer 300 may be inserted between an electrode 212 of a battery cell 210 and a separator 216. When the electrode 212 is a cathode, it may be provided to determine the open circuit voltage 220 of the electrode 212 and/or the battery cell 210 by measuring a potential state of the cathode relative to a corresponding anode of the battery cell 210. When the electrode 212 is an anode, it may be provided to determine the open circuit voltage 220 of the electrode 212 and/or the battery cell 210 by measuring a potential state of the anode relative to a corresponding cathode of the battery cell 210.

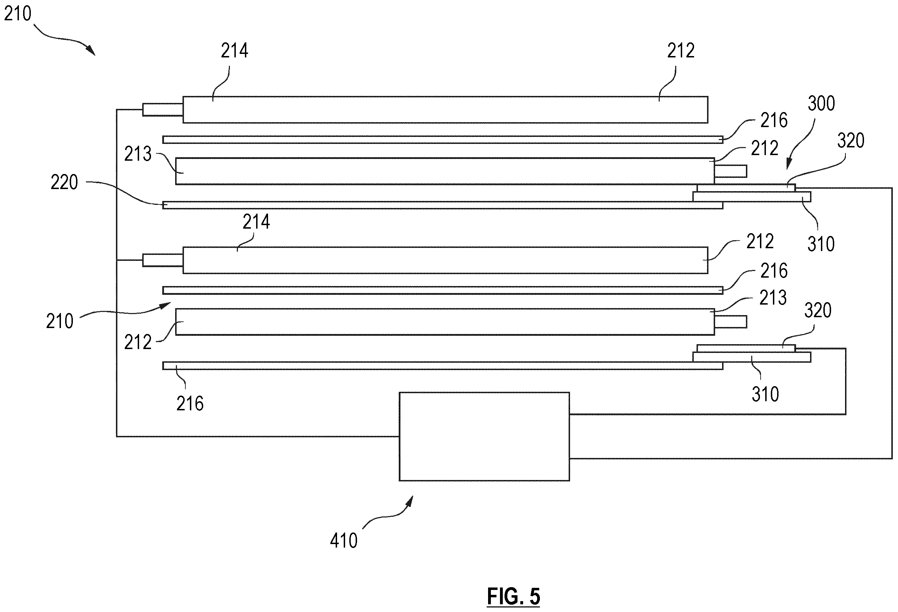

Figure 5 shows another embodiment of a battery module 200 and sensing spacers 300.

The battery module 200 may comprise multiple battery cells 210, each having electrodes 212. The electrodes 212 may be exposed for contact. Tabs 218 of the electrodes 212 may also be exposed. Each battery cell 210 may be separated by a separator 216. The separator 216 may be positioned between adjacent battery cells 210 to provide insulation. A separator 216 may further be positioned between two electrodes 212 of a battery cell 210, such as between a cathode 213 and an anode 214.

In some embodiments, it may be provided that the sensing spacers 300 may contact at least one, several or all of the cathodes 213. In some embodiments, the anodes 214 may be connected in parallel and the respective cathodes 213 may be individually insulated by the base elements 310 of the sensing spacers 300. Then, based on the overall anode potential, it may be possible to measure the potential state of the respective cathode 213, which may correspond to the open circuit voltages 220 of the individual cathodes 213 and/or the respective battery cells 210.

In some embodiments, it may be provided that the sensing spacers 300 may contact at least one, several or all of the anodes 214 (not shown in figure 5). In some embodiments, the cathodes 213 may be connected in parallel and the anodes 214 may be individually insulated by the base elements 310 of the sensing spacers 300. Then, based on the overall cathode potential, it may be possible to measure the potential state of each anode, which may correspond to the open circuit voltages 220 of the individual anodes 214 and/or the respective battery cells 210.

It may be provided that the sensing spacers 300 may contact the respective electrodes 212. It may be provided that the sensing spacers 300 may contact respective tabs 218 of the electrodes 212.

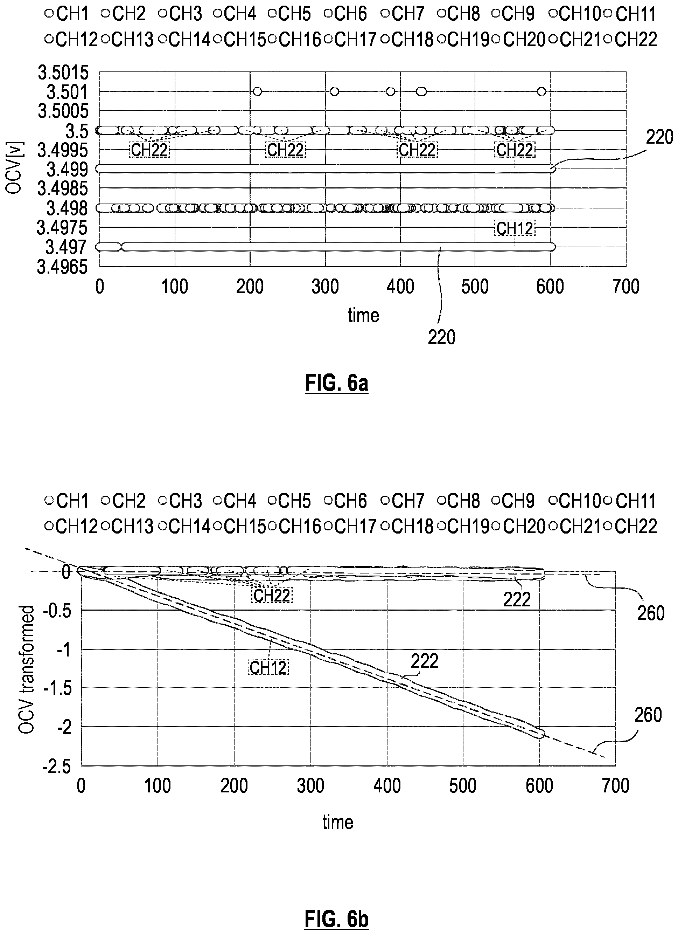

Figure 6a illustrates a graph showing the open circuit voltages (OCV) 220 of various battery cells over time. The x-axis may represent time in seconds, while the y-axis may represent the open circuit voltage values in volts for different electrodes 212 and/or different battery cells (CH1 to CH22). The open circuit voltage 220 for each electrode 212 and/or battery cell 210 is plotted at multiple time steps 270, demonstrating the voltage behavior of each electrode 212 and/or battery cell 210 over the observed period. A time step 270 may correspond to a value of the open circuit voltage, as e.g. indicated by a dot in the graph. Each dot in the graph may correspond to an open circuit voltage 220 determined at a respective time step 270.

Figure 6b illustrates a graph showing transformed open circuit voltages 222 of the same battery cells 210 over time. The x-axis may represent time in seconds, while the y-axis may represent the transformed open circuit voltages for different electrodes 212 and/or different battery cells 210 (CH1 to CH22). The transformed open circuit voltages 222 may be plotted at multiple time steps 270, demonstrating the normalized voltage behavior of each electrode 212 and/or battery cell 210 over the observed period. The graph includes trend lines 260, which may be used to identify any decreasing trends in the voltage levels, indicating potential abnormal voltage drops in the battery cells.

The transformed open circuit voltage 222 may be, may correspond and/or may comprise a difference 250 between a cumulative sum 230 of open circuit voltages 220 for a respective battery cell 210 and a mean open circuit voltage 240, and/or between a cumulative sum 230 of open circuit voltages 220 for a respective electrode 212 and a mean open circuit voltage 240. The cumulative sum 230 may be calculated by summing the respective open circuit voltages 220 up to and including a given time step 270. It may be provided that for each time step 270, a cumulated sum 230 may be calculated. The mean open circuit voltage 240 may then be calculated from these cumulative sums 230. The mean open circuit voltage 240 may be calculated for each time step 270. The mean open circuit voltage 240 of a time step 270 may be an average and/or mean of all cumulated sums 230 for a given time step 270. The difference between the cumulative sum 230 of each battery cell 210 and the mean open circuit voltage 240 may be calculated for each time step 270. The difference 250 between the cumulative sum 230 of each electrode 212 and the mean open circuit voltage 240 may be calculated for each time step 270. If the difference decreases over time, it may indicate that the battery cell 210 has an abnormal voltage drop. The trend lines 260 may be used to visualize these decreasing differences 250 over time, and/or to determine a decreasing difference 250.

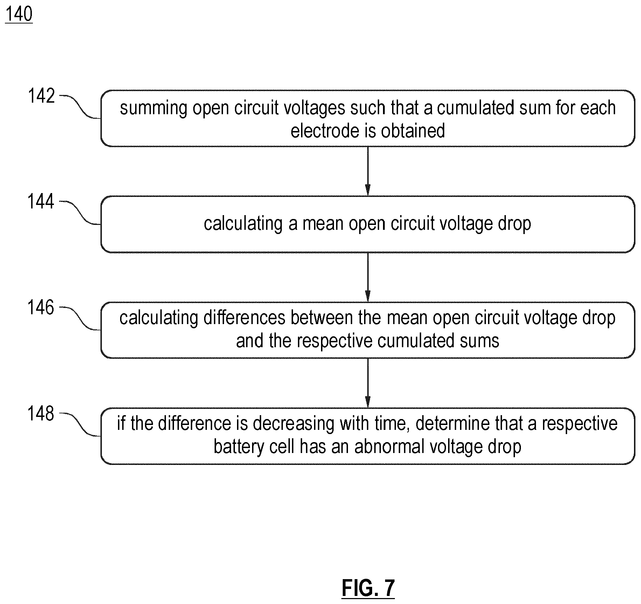

Figure 7 illustrates an exemplary embodiment of step 140 of method 100 for determining whether a battery cell 210 has an abnormal voltage drop. Figure 7 shows an example of the step of determining whether a battery cell has an abnormal voltage drop.

The step 140 may begin with step 142, which may involve summing open circuit voltages 220 such that a cumulated sum 230 for each battery cell 210 and/or electrode 212 is obtained.

Following step 142, the method may proceed to step 144. In step 144, the method may include calculating a mean open circuit voltage drop 240. This mean open circuit voltage 240 may be derived from the cumulated sums 230 obtained in the previous step. The mean open circuit voltage drop 240 may serve as a reference point for subsequent calculations.

Step 146 may follow, where the method may involve calculating differences 250 between the mean open circuit voltage drop 240 and the respective cumulated sums 230.

The method may proceed to step 148. In step 148, the method may determine that a respective battery cell 210 has an abnormal voltage drop if the calculated difference 250 is decreasing with time. This determination may be based on the trend of the differences calculated in step 146. If the difference shows a decreasing trend, it may indicate that the battery cell 210 associated with the respective difference 250 has an abnormal voltage drop.

It may be provided that the differences 250 may be or may correspond to transformed open circuit voltages 222. In some embodiments, transformed open circuit voltages 222 may be or may correspond to the differences 250.

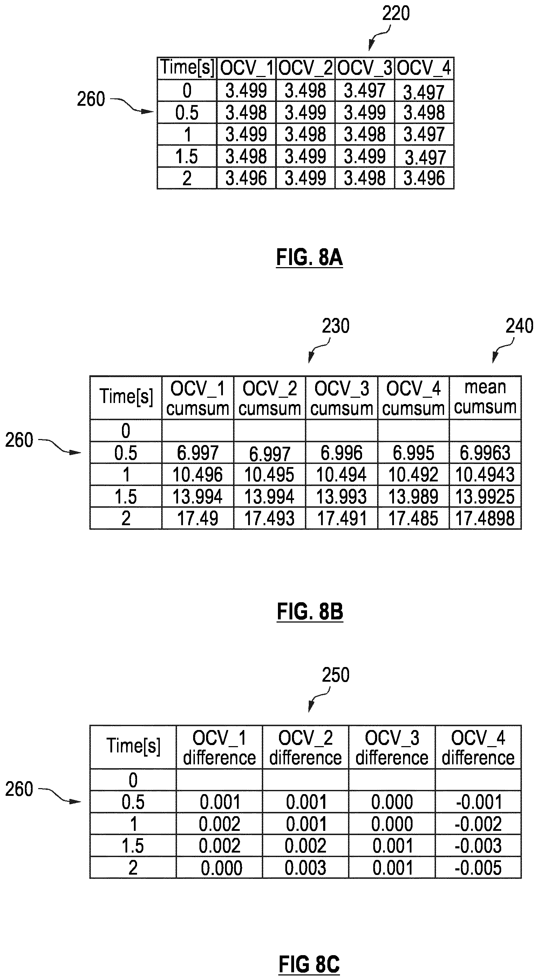

Figure 8a illustrates a table representing open circuit voltages (OCV 220) of four battery cells 210 over time. Each row of the table may correspond to a different time step 270. The respective open circuit voltage values for each battery cell 210 (OCV_1, OCV_2, OCV_3, OCV_4) for the respective time steps 270 are given in the respective columns. The time steps 270 may be recorded at 0, 0.5, 1, 1.5, and 2 seconds. The open circuit voltages may be measured in volts and recorded at each time step 270. The number of battery cells 210 and/or time steps 270 is not necessarily limited to this specific example.

Figure 8b illustrates a table representing the cumulative sum (cumsum) 230 of the open circuit voltages (OCV) for each battery cell 210 over time. Each row of the table may correspond to a different time step 270. The table may include columns for the cumulative sum 230 of open circuit voltages for each battery cell (OCV_1 cumsum, OCV_2 cumsum, OCV_3 cumsum, OCV_4 cumsum), and the corresponding mean open circuit voltage 240. The cumulative sum 230 for each battery cell 210 may be calculated by summing the respective open circuit voltages 220 (cf. fig. 8a) from the initial time step up to the current time step 270. The mean open circuit voltage may be calculated by averaging the cumulative sums of all battery cells 210 at each time step 270.

Figure 8c illustrates a table representing the differences 250 between the cumulative sum 230 of the open circuit voltages for each battery cell 210 and the mean open circuit voltage 240 at time steps 270. Each row of the table may correspond to a different time step 270. The table may include columns the respective differences250 for each battery cell 210 (OCV_1 difference, OCV_2 difference, OCV_3 difference, OCV_4 difference). The differences 250 may be calculated by subtracting the mean open circuit voltage cumulative sum from the cumulative sum 230 of each battery cell 210 at each time step 270. This table may be used to identify any deviations in the voltage behavior of individual battery cells compared to the average behavior of all cells.

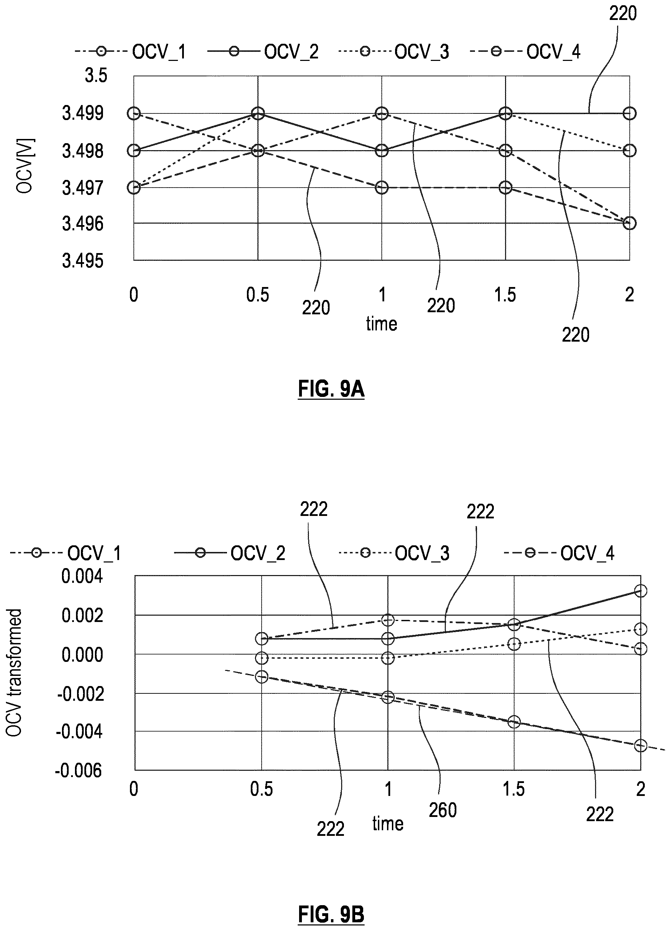

Figure 9a shows a graph illustrating the table of fig. 8a. In Figure 9a, open circuit voltages 220 of the four battery cells 210 of table 8a are shown. The x-axis represents time in seconds, while the y-axis represents the open circuit voltage in volts V. The open circuit voltages 220 are plotted at different time steps 270, specifically at 0, 0.5, 1, 1.5, and 2 seconds

Figure 9b shows a graph illustrating the differences 250 as shown in the table of fig. 8c and/or transformed open circuit voltages 222. The x-axis represents time in seconds, while the y-axis represents the differences 250 and/or transformed open circuit voltages The differences and/or transformed open circuit voltages 222 are plotted at different time steps 270, specifically at 0, 0.5, 1, 1.5, and 2 seconds. Additionally, the graph includes a trend line 260, which may be used to determine if the difference 250 is decreasing over time. This trend line 260 may be determined using statistical methods such as linear regression. It may be provided to determine a trend line 260 for each battery cell 210 and/or electrode.

The graphs in Figures 9a and 9b may be used together to monitor and analyze the open circuit voltages 210 of battery cells 210 and/or of electrodes 212 in a battery module 200. The trend line 260 in Figure 9b may provide additional insight into the behavior of the battery cells 210 and/or electrodes 212 over time, helping to determine if a battery cell 210 is experiencing an abnormal voltage drop.

While figures 9a and 9b have been described with reference to open circuit voltages of battery cells, open circuit values of electrodes could be treated and/or presented equivalently or similarly.

In some embodiments, it may be provided to stop the method early, and/or to determine that a battery cell may have an abnormal voltage drop early. In some embodiments, it may be provided to stop the method before a given or specific running time, and/or to determine that a battery cell may have an abnormal voltage drop a given or specific running time. For instance, when the trend line 260 may be decreasing, and the slop of the trend line 260 may not change more than a specified threshold over a specific number of time steps, the method may stop and it may be determined that a respective battery cell associated with the decreasing trend line may have an abnormal voltage drop.

The method, or at least some steps of the method, may be carried out in real time. In some embodiments, determining the open circuit voltage and/or determining whether a battery cell has an abnormal voltage drop may be carried out in real time.

In some embodiments, transforming the determined open circuit voltages relative to each other may be carried out in real time. In some embodiments, calculating the cumulated sum, calculating the mean open circuit voltage and/or calculating the difference at a time step may be carried out in real time, e.g. substantially immediately after determining the open circuit voltages at the time step.

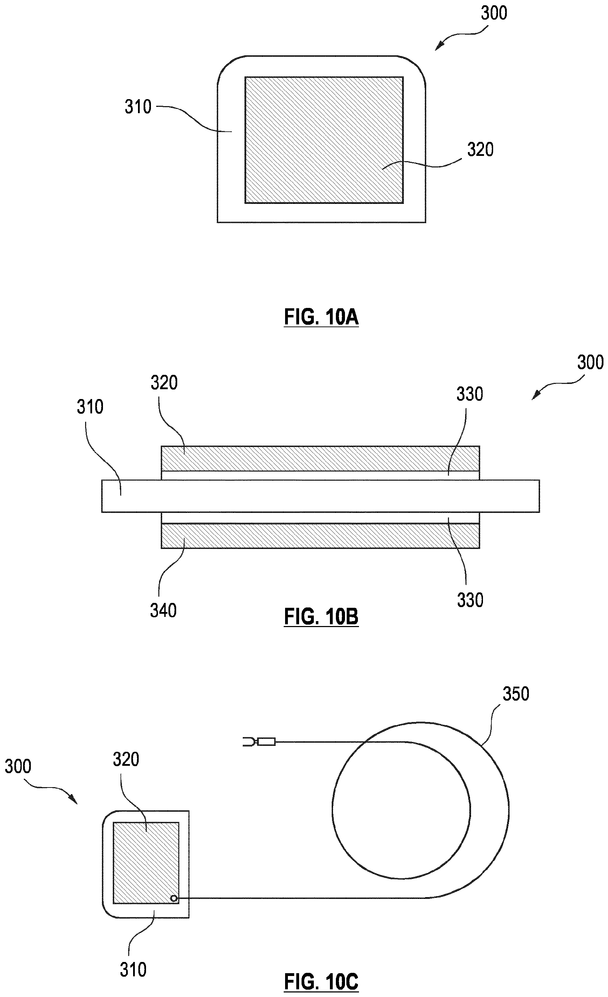

Figure 10a shows a top view of a sensing spacer 300. The sensing spacer 300 may comprise a base element 310. The base element 310 may be or may comprise a base layer. The base layer may be or may comprise an OHP film. An electrically conducting element 320 may be arranged on the base element 310. The electrically conducting element 320 may be configured to contact an electrode 212, preferably a tab 218 of an electrode 212.

The base element 310 may be non-conductive and/or electrically insulating. The electrically conducting element may be made of or comprise an electrically conducting material, such as e.g. copper.

The surface area of the electrically conducting element 320 may be smaller than the surface area of the base element 310. The ratio of the surface area of the electrically conducting element 320 to the surface area of the base element 310 may be between 0.3 to 0.9. In some embodiments, the ratio of the surface area of the electrically conducting element 320 to the surface area of the base element 310 may be between 0.5 and 0.75. In some embodiments, the ratio of the surface area of the electrically conducting element 320 to the surface area of the base element 310 may be around 0.6.

The base element 310 may be substantially plate-shaped and/or substantially flat. The electrically conducting element 320 may be substantially plate-shaped and/or substantially flat. The surface area of the base element 310 may be in some embodiments between 40mm x 40 mm and 80 mm x 80 mm. In an exemplary embodiment, the surface area of the base element 310 may be around 60 mm x 50 mm. The surface area of the electrically conducting element 320 may be in some embodiments between 30 mm x 30 mm and 60 mm x 60 mm. In an exemplary embodiment, the surface area of the electrically conducting element 320 may be around 45 mm x 40 mm.

Figure 10b illustrates a cross-sectional view of a sensing spacer 300. The electrically conducting element 320 may be arranged on one side of the base element 310. In some embodiments, another electrically conducting element 340 may be arranged on the opposite side of the base element 310. The sensing spacer 300 may also comprise an adhesive 330. The adhesive330 may be positioned between the base element 310 the electrically conducting element 320. Another adhesive 330 may be positioned between the base element 310 and the another electrically conducting element 340. It may be provided that the sensing spacer 330 may comprise another wire (not shown) in contact with the another electrically conducting element 340. The another wire may be used to transmit measurements, e.g. open circuit voltages, from the another electrically conducting element to a detecting unit.

The another electrically conducting element 340 may have a shape and/or dimensions equal or at least similar to the conducting element 320.

Figure 10c depicts a perspective view of the sensing spacer 300 with a wire 350. The wire 350 may be or may comprise an insulated wire 350. The wire 350 may be used for connecting the sensing spacer 300 to a detecting unit. The wire 350 may be electrically coupled to the electrically conducting element 320.

The sensing spacer 300 may be used in a system for determining whether a battery cell of a battery module has an abnormal voltage drop. The base element 310 may provide structural support. The electrically conducting element 320 may facilitate electrical contact with an electrode. The another electrically conducting element 340 may provide additional electrical contact points. The base element 310 may be electrically insulating. The base element 310 may prevent electrical short circuits. The wire 350 may enable connection to external detecting units.

The sensing spacer 300 may be inserted between an electrode 212 and a separator 216 of a battery cell 210, and/or between a tab 218 of an electrode 212 and a separator 216. The base element 310 may partially insulate the electrode 210. The electrically conducting elements 320 and 340 may contact electrodes 212 to determine open circuit voltages. The insulated wire 350 may transmit these measurements to a detecting unit.

The sensing spacer 300 may be configured to determine open circuit voltages in real time.

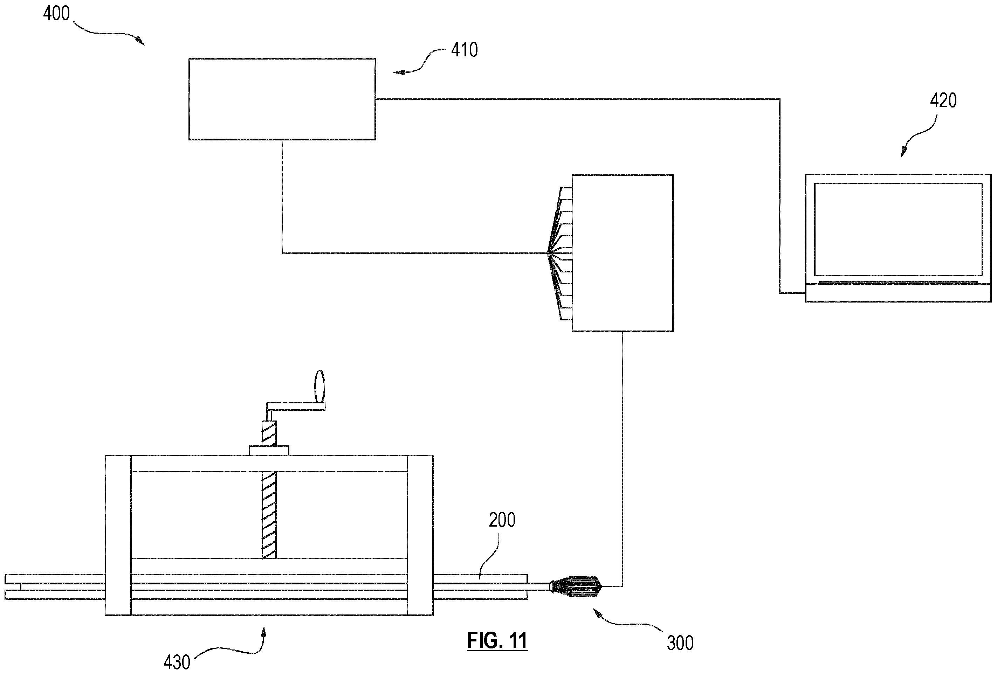

Figure 11 illustrates an embodiment of a system 400 for determining whether a battery cell 210 of a battery module 200 has an abnormal voltage drop.

The system 400 may comprise a detecting unit 410. The detecting unit 410 may be configured to be electrically connected via sensing spacers 300 to electrodes 212 of the battery module 200, and/or to respective tabs 218 of electrodes 212. The detecting unit 410 may be further configured to determine open circuit voltages 220 of the electrodes 212 and/or battery cells 210 of the battery module 200 at multiple time steps 270.

The system 400 may also include a computing unit 420. The computing unit 420 may be configured to determine whether a battery cell 210 of the battery module 200 has an abnormal voltage drop based on the determined open circuit voltages 220. The computing unit 420 may be connected to the detecting unit 410 and may process data received from it.

The battery module 200 may be positioned within a pressing unit 430. The pressing unit 430 may be configured to apply pressure onto the battery module 200 when determining the open circuit voltages 220. The pressing unit 430 may include structural components to ensure uniform pressure distribution across the battery module 200.

The sensing spacers 300 may be connected to the electrodes 212, and/or tabs 218, of the battery module 200. The sensing spacers 300 may include an electrically conducting element 320 configured to contact the electrodes 212, and/or respective tabs 218 of the electrodes 212, of the battery cells 210. The sensing spacers 300 may be connected to the detecting unit 410 via respective wires 350.

The detecting unit 410 may include various electronic components to measure the open circuit voltages 220. The detecting unit 410 may be connected to the computing unit 420, which may be a laptop or another computing device. The computing unit 420 may include software to analyze the open circuit voltage data and determine if there is an abnormal voltage drop in any of the battery cells 210.

The system 400 may comprise and A/D converter. The A/D converted may be configured to convert values of determined voltages into digital values.

The embodiment shown in Figure 11 may be used for testing and monitoring the performance of battery cells in a controlled environment. The system 400 may provide real-time data on the voltage characteristics of the battery cells, allowing for early detection of potential issues.

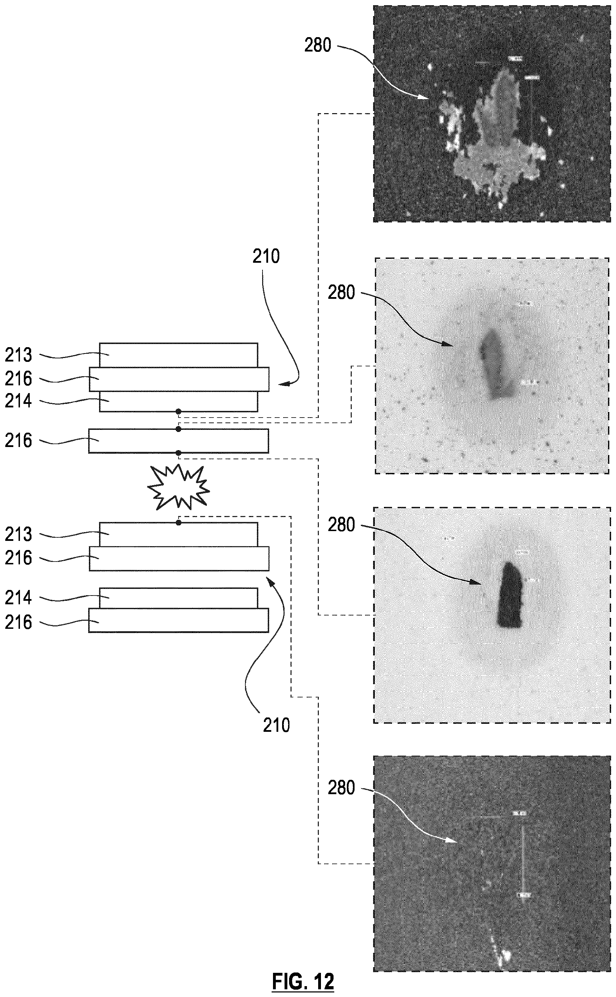

Figure 12 illustrates an exemplary embodiment of a battery module 200, detailing the internal structure and potential anomalies within the battery cells 210.

The battery module 200 may comprise multiple battery cells 210. Each battery cell 210 may include an anode 214 and a cathode 213, which may be separated by a separator 216. The separator 216 may be positioned between the anode 214 and the cathode 213 to prevent direct contact and potential short circuits.

In figure 12, an abnormality, such as an internal short circuit or damage within the battery cell 210, may be represented by the explosion icon. This abnormality may be due to various factors, including manufacturing defects.

Adjacent to the schematic representation of the battery cells 210, the figure includes several microscopic images. These images may illustrate different types of anomalies or defects 280 that can occur within the battery cells 210.

The first image at the top may show a metallic particle or dendrite formation, which could cause an internal short circuit. The second image may depict a puncture or tear, e.g. in the separator 216, potentially leading to direct contact between the anode 214 and the cathode 213. The third image may illustrate a burn mark or thermal damage, indicating overheating within the battery cell 210. The fourth image 280 at the bottom may show a contamination particle, which could affect the performance and safety of the battery cell210.

The features as disclosed in the claims, the description and/or the figures, by themselves or in any combination thereof, may be relevant for the realization of the invention.

### LIST OF REFERENCE NUMERALS

- 100: method
- 200: battery module
- 210: battery cell
- 212: electrode
- 213: cathode
- 214: anode
- 216: separator
- 218: tab
- 220: open circuit voltage
- 222: transformed open circuit voltage
- 230: cumulated sum
- 240: mean
- 250: difference
- 260: trend line
- 270: time step
- 280: defect
- 300: sensing spacer
- 310: base element
- 320: electrically conducting element
- 330: adhesive
- 340: another electrically conducting element
- 350: wire
- 400: system
- 410: detecting unit
- 420: computing unit
- 430: pressing unit

## Claims

1. A sensing spacer (300), the sensing spacer (300) comprising;
a base element (310); and
an electrically conducting element (320) arranged on the base element (310), the electrically conducting element (320) being configured to contact an electrode (212).

2. The sensing spacer (300) of claim 1, wherein a surface area of the electrically conducting element (320) is smaller than a surface area of the base element (310).

3. The sensing spacer (300) according to any of the preceding claims, comprising another electrically conducting element (340) being configured to contact an electrode (212), the another electrically conducting element (340) being arranged on a side of the base element (310) opposite the electrically conducting element (320).

4. A system (400) for determining whether a battery cell (210) of a battery module (200) to be tested has an abnormal voltage drop, the system (400) comprising:
a plurality of sensing spacers (300), each sensing spacer (300) having an electrically conducting element (320), the electrically conducting element (320) being configured to contact an exposed electrode (212) of a battery cell (210) of the battery module (200) to be tested;
a detecting unit (410), the detecting unit (410) being configured to be electrically connected via the respective sensing spacers (300) to electrodes (212) of the battery module (200) to be tested, the detecting unit (410) being further configured to determine open circuit voltages (220) of the electrodes (212) and/or battery cells (210) of the battery module (200) to be tested at multiple time steps (270); and
a computing unit (420) being configured to determine whether a battery cell (210) of the battery module (200) to be tested has an abnormal voltage drop based on the determined open circuit voltages (220).

5. The system (400) according to claim 4, further comprising a pressing unit configured for applying a pressure onto the battery module (200) when determining the open circuit voltages (220).

6. The system (400) according to claim 4 or 5, wherein the system (400) is configured to determine open circuit voltages (220) in real time and/or to determine whether a battery cell (210) of the battery module (200) to be tested has an abnormal voltage drop in real time.

7. A method (100) for determining whether a battery cell (210) of a battery module (200) has an abnormal voltage drop, the method (100) comprising the steps:
exposing electrodes (212) of battery cells (210) of the battery module (200);
contacting the exposed electrodes (212) with sensing spacers (300), such that each contacted electrode (212) is contacted by an electrically conducting element (320, 340) of a respective sensing spacer (300);
determining, at multiple time steps (270), open circuit voltages (220) of the electrodes (212) and/or battery cells (210) with the sensing spacers (300) contacting the exposed electrodes (212); and
determining whether a battery cell (210) has an abnormal voltage drop based on the determined open circuit voltages (220).

8. The method (100) according to claim 7, further comprising:
applying a pressure onto the battery module (200) when determining the open circuit voltages (220).

9. The method (100) according to claim 7 or 8, wherein when determining the open circuit voltages (220), all time steps (270) of the multiple time steps (270) are in a time interval of between 1 minute and 3 hours.

10. The method (100) according to any of the preceding claims 7 10 9, wherein determining the open circuit voltages (220) is carried out in real time, and/or wherein determining whether a battery cell (210) has an abnormal voltage drop is carried out in real time.

11. The method (100) according to any of the preceding claims 7 to 10, wherein determining whether a battery cell (210) has an abnormal voltage drop comprises transforming the determined open circuit voltages (220) relative to each other.

12. The method (100) according to any of the preceding claims 7 to 11, further comprising:
for each time step (270) and contacted electrode (212), summing the respective open circuit voltage (220) as determined up to and including the time step (270) such that a cumulated sum (230) of the open circuit voltage (220) of each respective electrode (212) and/or respective battery cell (210) is obtained;
for each time step (270), calculating a mean open circuit voltage (240) from the cumulated sums (230);
for each time step (270) and cumulative sum (230), calculating the difference (250) between the respective cumulated sum (230) and the mean open circuit voltage (240); and
if the difference (250) is decreasing with time, determine that the battery cell (210) which comprises the decreasing difference (250) has an abnormal voltage drop.

13. The method (100) of claim 12, further comprising:
determining a trend line (260) of the difference (250) to determine if the difference (250) is decreasing with time.

14. The method (100) according to any of the preceding claims 7 to 13, wherein contacting the exposed electrodes (212) with sensing spacers (300) comprises inserting a respective sensing spacer (300) between an electrode (212) and a separator (216) of at least one or all battery cells (210) of the battery module (200).

15. The method (100) according to any of the preceding claims 7 to 14, wherein when or after contacting the exposed electrodes (212) with sensing spacers (300), the respective electrodes (212) are at least partially insulated by the respective sensing spacer (300).
